(19) Europäisches Patentamt / European Patent Office / Office européen des brevets

(11) **EP 3 721 218 B1**

(12) **EUROPEAN PATENT SPECIFICATION**

(45) Date of publication and mention
of the grant of the patent:
**28.08.2024 Bulletin 2024/35**

(21) Application number: **18811037.3**

(22) Date of filing: **04.12.2018**

(51) International Patent Classification (IPC):
***G01N 27/22*** *(2006.01)*   ***B01D 67/00*** *(2006.01)*
***C23C 14/22*** *(2006.01)*   ***H01L 21/283*** *(2006.01)*

(52) Cooperative Patent Classification (CPC):
**G01N 27/223; C23C 14/225; H01L 28/60**

(86) International application number:
**PCT/EP2018/083470**

(87) International publication number:
**WO 2019/110582 (13.06.2019 Gazette 2019/24)**

(54) **METHOD FOR MANUFACTURING A HUMIDITY SENSOR AND HUMIDITY SENSOR**

VERFAHREN ZUR HERSTELLUNG EINES FEUCHTIGKEITSSENSORS SOWIE EIN
FEUCHTIGKEITSSENSOR

PROCÉDÉ DE FABRICATION D'UN CAPTEUR D'HUMIDITÉ ET CAPTEUR D'HUMIDITÉ

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **08.12.2017 EP 17306733**

(43) Date of publication of application:
**14.10.2020 Bulletin 2020/42**

(73) Proprietor: **TE Connectivity Sensors France
31027 Toulouse Cedex 3 (FR)**

(72) Inventor: **DURUPT, Emilien
31460 Francarville (FR)**

(74) Representative: **Johnstone, Douglas Ian et al
Baron Warren Redfern
1000 Great West Road
Brentford TW8 9DW (GB)**

(56) References cited:
US-A- 5 607 564        US-A- 5 607 564
US-A1- 2009 145 220    US-A1- 2010 134 948
US-A1- 2010 134 948    US-A1- 2011 179 861
US-A1- 2011 179 861    US-A1- 2012 247 203
US-A1- 2012 247 203    US-A1- 2013 233 073
US-A1- 2015 137 836

• SBERVEGLIERI G ET AL: "Characterization of
porous Al"2O"3-SiO"2/Si sensor for low and
medium humidity ranges", SENSORS AND
ACTUATORS B: CHEMICAL, ELSEVIER BV, NL,
vol. 23, no. 2/3, 1 February 1995 (1995-02-01),
pages 177 - 180, XP004004806, ISSN: 0925-4005,
DOI: 10.1016/0925-4005(94)01270-R

**Description**

The invention relates to a method for manufacturing a humidity sensor and a humidity sensor.

Such relative humidity sensors are known in the art. US 4,651,121 discloses a moisture sensor comprising a substrate, a bottom electrode over the substrate, and an organic moisture sensitive film sandwiched between the bottom electrode and an upper electrode. The capacitance of the sensor changes when water vapor enters the moisture sensitive film. This effect is used to determine variations in the amount of water vapor in the atmosphere by detecting the corresponding changes of the capacitance. Organic material based relative humidity sensors are intrinsically submitted to degrading because of chemical ageing of the material and are heat sensitive, amongst others due to a low glass temperature transition.

US 8,783,101 B2 discloses another relative humidity sensor based on a nano structured aluminum oxide thin film. It comprises an anodic aluminum oxide thin film form from an Al substrate which also serves as one electrode. A porous metal layer is formed over the anodic aluminum oxide thin film as a second electrode. This sensor is obtained by stamping an aluminum sheet and anodizing it to form the porous aluminum oxide, then the porous metal layer is formed over the aluminum oxide by sputtering. Using solderable electrode pins connected to the electrodes using spring contacts or conductive glue, the obtained sensor can be plugged or soldered into a circuit. The fabrication method disclosed can, however, not be implemented into high yield microfabrication means which would allow to remove all mechanical assembly steps and to reduce the part to part difference. The parts assembly is tedious and can lead to a lack of alignment precision. Furthermore an unwanted delamination of the parts can be observed.

US 2011/0179861 A1 discloses a capacitive humidity sensor including a nanoporous dielectric material such as SiOCH or MSQ positioned between capacitor electrodes.

US 5,607,564 discloses forming a microporous electrode structure on a substrate by a vacuum evaporation process using an evaporation angle between the substrate's surface and the evaporation source of less than 90 degrees.

It is therefore the object of the present invention to improve the manufacturing of relative humidity sensors using an inorganic humidity sensitive layer.

This object is achieved with a method of manufacturing a relative humidity sensor according to claim 1. The method comprises the steps of: a) providing a bottom substrate, b) providing a first electrode and an electrical connection means on or over the substrate, c) providing an insulating layer for electrically isolating the first electrode from the electrical connection means, d) providing an inorganic porous dielectric layer over the insulating layer in the area of the first electrode by depositing an aluminum layer on the insulating layer and growing the porous alumina layer by electrolytic growth, and e) providing a porous second electrode, in or over the porous dielectric layer by depositing a conductive layer by grazing incidence deposition and electrically connecting the second electrode to the electrical connection means. By providing an insulating layer it becomes possible to take advantage of microfabrication process steps leading to high yields and reliability. Using microfabrication the assembly of the various parts is simplified and alignment can be achieved within the tight limits of microfabrication in contrast to a mechanical assembly like in the prior art. At the same time the obtained sensor is less exposed to ageing than sensors with an organic dielectric and a wider temperature range, in particular for temperatures even exceeding 300°C, can be used.

The inorganic porous dielectric layer comprises Alumina which may be grown using high yield manufacturing methods.

Step d) comprises a step of depositing an aluminum layer and a step of growing a porous alumina layer by electrolytic growth. For example, a solution of oxalic acid can be used for the electrolytic growth, with the growth being driven by an electrolytic electrical current. Electrolytic growth can be realized in an environment of microfabrication and allows the growth of porous layers suitable for use in a relative humidity sensor.

According to an embodiment, an electric conductive drain can be provided in the insulating layer to electrically connect the aluminum layer with the first electrode. Thus during the electrolytic growth the drain allows draining the electrical current via the first electrode.

According to an embodiment, a plurality of relative humidity sensors can be formed on the same bottom substrate and the first electrodes are then provided such that they are electrically connected to each other. This feature simplifies the set-up to realize the electrolytic growth.

According to an embodiment, the porosity of the inorganic porous dielectric layer is in a range of 5% to 99%. In this range of porosity the moisture from the probed fluid or gas can enter the dielectric space and thus modify the capacitance by permeating through the porous network and can get absorbed on the structure.

Step e) of providing the second electrode comprises depositing a conductive layer by grazing incidence deposition. Grazing incidence deposition has the advantage that the deposited particles or atoms do not penetrate deeply into the porous network so that the electrode layer essentially remains on the surface of the porous dielectric layer. The thickness of the penetration depth d scales as:

$$d \propto \Phi \tan \alpha \qquad \text{EQ. 1}$$

For each one of the pores, the length $\Phi$ being the pore diameter and a being the angle between the particle or atomic beam and the surface of the porous network.

According to an embodiment, the grazing incidence deposition can be a metal vapour grazing incidence deposition. With a vapour deposition technique, e.g. sputtering, ebeam evaporation, or any other suitable deposition method, a grazing incidence deposition can be realized by providing the target towards the side of the substrate instead of providing it opposite the surface of the substrate.

According to an embodiment, the angle of evaporated material flow and the surface of the inorganic porous dielectric layer can be less than 45°, in particular less than 30°. The lower the deposition angle, the less atoms will be deposited inside the porous layer and the lower the penetration depth into the porous material, thereby improving the electric properties of the sensor compared to a deposition under 90°.

According to an embodiment, the substrate is a passive substrate, in particular a Si substrate, or an application-specific integrated circuit (ASIC) type substrate.

According to an embodiment, the method can comprise a step of providing a conductive layer on the first electrode prior to step c). The conductive layer forms the counter electrode to the second electrode and its shape can be adapted to get an improved electric coupling and therefore improve the capacitive properties of the sensor.

According to an embodiment, the thickness of the inorganic porous dielectric layer can be in a range between $1\mu m$ to $5\mu m$ and the lateral extension can be in a range between $10\mu m$ to $800\mu m$ at least in one dimension. Using the inventive method, it is possible to further reduce the size of the sensor while keeping the efficiency of detecting relative humidity.

The object of the invention is also achieved, with a relative humidity sensor, in particular obtained by the method described above, and comprising: a substrate, a first and a electrical connection means on or over the substrate, an insulating layer over the first electrode and at least excluding the electrical connection means, an inorganic porous dielectric layer over the insulating layer and a second electrode, in particular a porous second electrode, electrically connected to the electrical connection means in or over the inorganic porous dielectric layer.

The inventive humidity sensor can be fabricated using microfabrication means with high yields of over 90% and reliability. Due the use of an inorganic dielectric, chemical ageing like for organic layers can be reduced or prevented. Further, a sensor working for temperatures of 300°C or more can be achieved. Thus, the obtained inventive sensor functions in a range that is larger than the temperature range of sensors with an organic dielectric layer. The sensor can be used to detect humidity in gas and/or water in oil or other fluids.

According to an embodiment, the inorganic porous layer comprises Alumina with a porosity of 5% to 99% and/or a thickness of 200nm to $10\mu m$. According to an embodiment, the second electrode can be a gold or any vapor phase deposited conductive porous layer.

The invention will now be described in greater detail using advantageous embodiments in an exemplary manner and with reference to the drawings. The described embodiments are merely possible configurations and it must be borne in mind that the individual features as described above can be provided independently of one another or can be omitted altogether while implementing this invention.

Figures 1      a-1f schematically illustrate the method of manufacturing a relative humidity sensor according to the invention,

Figures 2a and 2b      illustrate variants of the first embodiment illustrated in Figures 1a to 1f,

Figure 3      illustrates a top view of the porous dielectric layer,

Figure 4      shows details of the second electrode deposition by grazing incidence deposition.

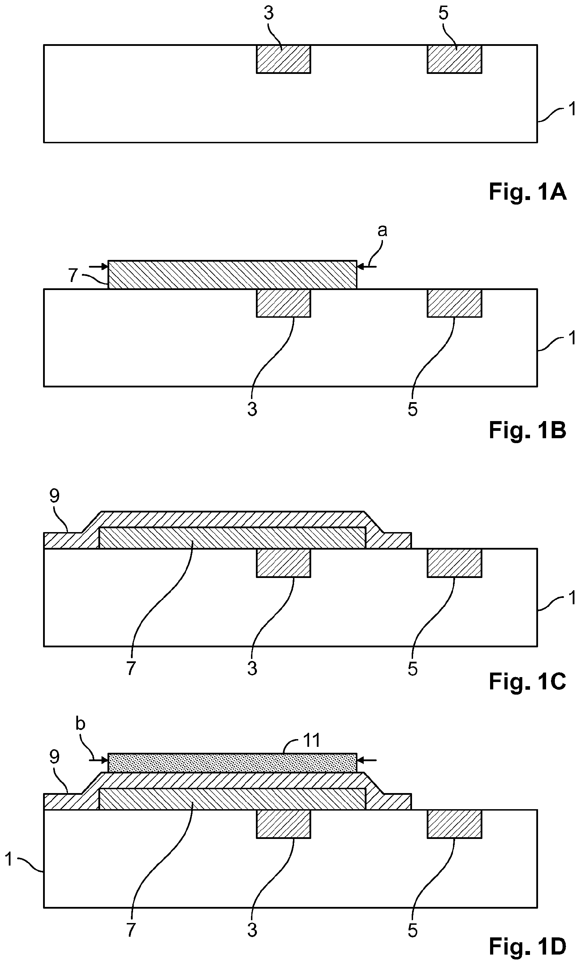

Figures 1a to 1f illustrate the method of manufacturing a relative humidity sensor according to the invention. It illustrates the formation of one relative humidity sensor, it is, however, to be understood that the described process is a micro fabrication process allowing the formation of a plurality of sensor structures at the same time.

Figure 1a shows a substrate 1. In the following process steps the various layers necessary to build the relative humidity sensor will be formed. The substrate 1 has already been processed using layer deposition and patterning steps, so that a first electrode 3 and an electrical connection means 5 are present in or on the surface of the substrate 1. The substrate 1 can be a silicon substrate, a sapphire substrate or any other substrate used in microfabrication production lines. As an alternative an application-specific integrated circuit (ASIC) could also be used as a starting material of the process according to the invention. The first electrode and the electrical connection means are metallic, e.g. from Al, Cu, Au or from any other suitable material.

Figure 1b illustrates the result of a further layer deposition and patterning step to obtain a conductive layer 7 on the first electrode 3. Preferably the conductive layer 7 is made of the same material as the first electrode. It has a thickness in a range of 10 to 500nm. The conductive layer 7 has a lateral extension in a range of 10μm to 800μm at least in one dimension.

Figure 1c illustrates the result of an insulating layer deposition and patterning step. The obtained insulating layer 9 laterally extends over the conductive layer 7 and the first electrode 3 but does not cover the electrical connection means 5. The insulating layer 9 can be SiO2 layer or made from any other suitable insulating material. It has a thickness in a range of 1nm to 500nm.

Figure 1d illustrates the result an aluminum deposition and patterning step. The aluminum layer 11 which will be transformed in a dielectric layer in the following process step, has a thickness of 1nm to 1000nm and essentially has a lateral extension b corresponding to the lateral extension a of the conductive layer 7.

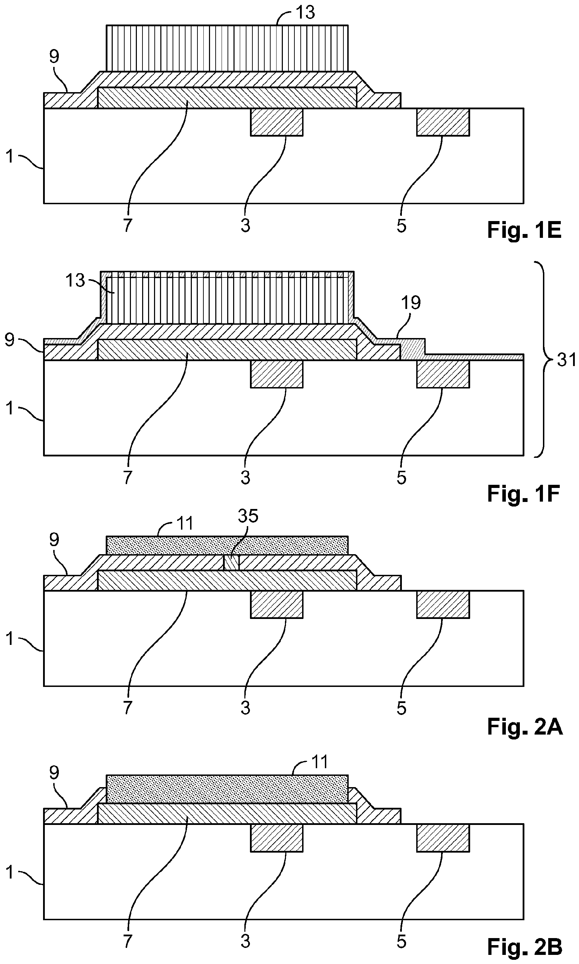

Figure 1e illustrates the result of an electrolytic growth step transforming the aluminum layer 11 into a porous dielectric alumina layer. The electrolytic growth is realized in an acidic medium, e.g. oxalic acid and is electrically driven. It turns the Al layer 11 into the porous dielectric alumina layer 13. The dielectric alumina layer 13 has a thickness of 1μm to 5μm and has essentially the same lateral extension as the conductive layer 7. The growth conditions are furthermore controlled such that the entire Aluminum layer 11 is transformed into alumina.

Figure 2a illustrates a first variant of the inventive process with additional process steps introduced between the process as illustrated by figures 1d and 1e. Prior to depositing the aluminum layer 11, one or more via holes are etched into the insulating layer 9 in the area over the conductive layer 7 and filled with a conductive material, e.g. Al to provide an electrical drain 35 in the insulating layer 9. The drain 35 allows using the first electrode 3 as a current drain during the electrolytic growth, in particular when, on a wafer scale, the first electrodes 3 are all electrically interconnected.

Figure 2b illustrates a second variant of the inventive process. Instead of depositing the aluminum layer 11 onto the insulating layer 9 as illustrated in Figure 1d, it is directly deposited onto conductive layer 7 on the bottom electrode 3. To do so, the patterning step associated with the step illustrated in Figure 1c is realized such that the surface of the conductive layer 7 becomes at least partially free so that the aluminum, layer 11 can then be deposited onto layer 9. Also in this case the bottom electrodes are interconnected at the wafer scale and current drain during the electrolytic growth can be provided.

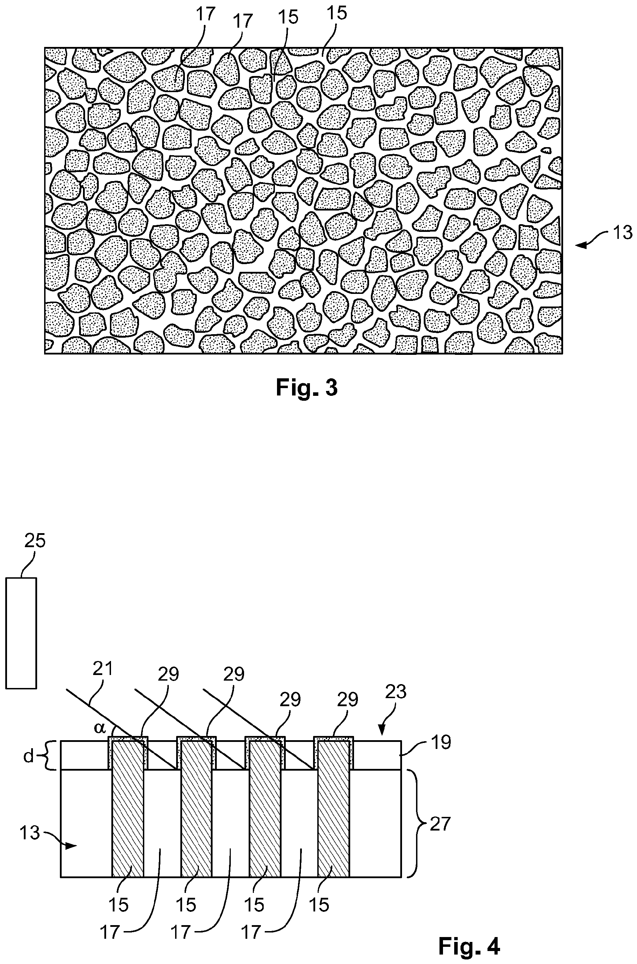

Figure 3 shows a top view onto the porous dielectric layer 13. It illustrates a channel matrix formed by Alumina walls 15 and voids 17. Depending on the growth conditions a porosity of 5% to 99% can be achieved.

Figure 1f illustrates the result of a deposition step to form a second electrode 19 over the porous dielectric alumina layer 13. The second electrode 19 is in electric contact with the electrical connection means 5. This can be achieved in the same process step or by an additional layer deposition and patterning step. In this embodiment the second electrode layer is a gold layer, but any other suitable conductor could be used in variants. The second electrode 19 has a typical thickness in a range of 0.2nm to 30nm.

Afterwards, the substrate is diced and individual sensors are packaged. When using interconnected first electrodes 3 as current drain, like explained above with respect to Figure 2a and 2b, the dicing will isolate the first electrodes 3 from each other.

Figure 1f also illustrates the structure of the inventive relative humidity sensor 31. This sensor 31 functions as follows. Humidity in a gas or fluid can enter the porous channel matrix, thereby changing the dielectric properties of the porous alumina layer 13. This change in turn can be sensed by a change in the capacitance of the capacitor formed by the conductive layer 7, the porous Alumina layer 13 and the second electrode 19. Via the first electrode 3 and the electrical connection means 5 the corresponding signals can be output to the sensor's control circuit. The absence of organic material provides long term stability and an extended temperature range in which the sensor functions. Indeed, the sensor can work for temperatures even exceeding 300°C. Due to the use of micro fabrication process steps it is furthermore possible to mass produce with high yield and reliability.

Figure 4 illustrates schematically the deposition process of the step illustrated in Figure 1f. The deposition method used according to the invention is a grazing incidence deposition based on a vapour deposition method. In this method the flow of evaporated atoms 21, e.g. Gold atoms, does not impinge perpendicular to the surface like in standard deposition methods but arrive on the surface of the porous dielectric alumina layer 13 under an angle α that is essentially less than 45°, in particular less than 30°, with respect to the surface 23 of the porous dielectric alumina layer 13 and taking into account the divergence of the beam. This can be achieved by providing the evaporation target 25 on the side of the substrate 1 instead of opposite to the substrate 1 like in conventional evaporation processes. In addition, the substrate 1 can be rotated around its normal axis during grazing incidence deposition to ensure the homogeneity of the deposited layer with respect to the substrate orientation.

The deposition under an angle smaller than 45°, in particular less than 30°, also has the advantage that the penetration depth d can be kept small (cf. EQ. 1) due to the shading effect of the neighbouring alumina walls 15 leading to a shaded area 27 without deposited atoms. The penetration depth d scales like:

$$d \propto \Phi \tan \alpha$$

For each one of the pores, the length Φ being the pore diameter of the porous network, and a being the angle between the gold beam and the surface of the porous layer 13.

As can be seen on Figure 4, the second electrode 19 in this embodiment is porous like the underlying porous layer 13 with the alumina walls 15 and voids 17, which allows the moisture to enter the porous layer 13.

The areas 29 with deposited atoms actually form the second electrode 19.

In the above description the terms deposition step and patterning relate to standard fabrication steps used in the semiconductor manufacturing. As an example deposition step can relate to chemical vapour deposition (CVD) or physical vapour deposition (PVD) and patterning step can relate to a lithography imaging and dry or wet etching step.

Modifications to embodiments of the invention described in the foregoing are possible without departing from the scope of the invention as defined by the accompanying claims. Expressions such as "including", "comprising", "incorporating", "consisting of", "have", "is" used to describe and claim the present invention are intended to be construed in a non-exclusive manner, namely allowing for items, components or elements not explicitly described also to be present. Reference to the singular is also to be construed to relate to the plural.

**Reference numerals:**

1    substrate
3    first electrode
5    electrical connection means
7    conductive layer
9    insulating layer
11   Aluminum layer
13   porous Alumina layer
15   Alumina walls
17   voids
19   second electrode
21   flow of evaporated atoms
23   surface of porous layer
25   evaporation target
27   shaded area
29   areas with deposited atoms
31   relative humidity sensor
35   electrical drain
a    lateral extension of layer 7
b    later extension of layer 11
d    penetration depth
α    angle between evaporated atoms impinging on surface 23

**Claims**

**1.** Method of manufacturing a relative humidity sensor comprising the steps of:

a) providing a bottom substrate (1),
b) providing a first electrode (3) and electrical connection means (5) on or over the substrate (1),
c) providing an insulating layer (9) to electrically isolate the first electrode (3) from the electrical connection means,
d) providing a porous alumina dielectric layer (13) over the insulating layer (9) in the area of the first electrode (3) by depositing an aluminum layer (11) on the insulating layer (9) and growing the porous alumina layer (13) by electrolytic growth, and
e) providing a porous second electrode (19) in or over the porous dielectric layer (13) by depositing a conductive layer by grazing incidence deposition and electrically connecting the second electrode to the electrical connection means (5).

**2.** The method according to claim 1, wherein an electric conductive drain (35) is provided in the insulating layer (9) to electrically connect the aluminum layer (11) with the first electrode (3).

**3.** The method according to claim 1 or 2, wherein a plurality of relative humidity sensors are formed on the same bottom substrate (1) and wherein the first electrodes (3) are provided such that they are electrically connected to each other.

**4.** The method according to one of claims 1 to 3, wherein the porosity of the inorganic porous dielectric layer (13) is in a range of 5% to 99%.

**5.** The method according to any one of the preceding claims, wherein the grazing incidence deposition is a metal vapour grazing incidence deposition.

**6.** The method according to any one of the preceding claims, wherein the angle of evaporated material flow and the surface of the inorganic porous dielectric layer (13) is less than 45°, in particular less than 30°.

**7.** The method according to any one of the preceding claims, wherein the substrate (1) is a passive substrate, in particular a Si or sapphire substrate, or an application-specific integrated circuit (ASIC) type substrate.

**8.** The method according to any one of the preceding claims, further comprising a step of providing a conductive layer (7) on the first electrode (3) prior to step c).

**9.** The method according to one any one of the preceding claims, wherein the thickness of the inorganic porous dielectric layer (13) is in a range between $1\mu m$ to $5\mu m$ and the lateral extension is in a range between $10\mu m$ to $800\mu m$ at least in one dimension.

**10.** A relative humidity sensor comprising:

a substrate (1),
a first electrode (3) and an electrical connection means (5) on or over the substrate (1),
an insulating layer (9) to electrically isolate the first electrode (3) from the electrical connection means (5),
an electrolytically grown porous alumina dielectric layer (13) over the insulating layer (9) in the area of the first electrode (3), and
a porous second electrode (19) comprising a conductive layer electrically connected to the electrical connection means (5) and provided in or over the inorganic porous dielectric layer (13) by grazing incidence deposition.

**11.** As relative humidity sensor according to claim 10, **characterized in that** the inorganic porous layer (13) comprises Alumina with a porosity of 5% to 99% and a thickness of $1\mu m$ to $5\mu m$.

**12.** A relative humidity sensor according to claim 10 or claim 11, wherein the second electrode (19) is a gold layer.


**Patentansprüche**

**1.** Verfahren zur Herstellung eines Relativfeuchtigkeitssensors, das die folgenden Schritte beinhaltet:

a) Bereitstellen eines unteren Substrats (1),
b) Bereitstellen einer ersten Elektrode (3) und elektrischer Verbindungsmittel (5) auf oder über dem Substrat (1),
c) Bereitstellen einer Isolierschicht (9), um die erste Elektrode (3) von den elektrischen Verbindungsmitteln elektrisch zu isolieren,
d) Bereitstellen einer porösen dielektrischen Aluminiumoxidschicht (13) über der Isolierschicht (9) im Bereich der ersten Elektrode (3) durch Abscheiden einer Aluminiumschicht (11) auf der Isolierschicht (9) und Aufwachsenlassen der porösen Aluminiumoxidschicht (13) durch elektrolytisches Wachstum, und
e) Bereitstellen einer porösen zweiten Elektrode (19) in oder über der porösen dielektrischen Schicht (13) durch Abscheiden einer leitfähigen Schicht durch streifenden Einfall und elektrisches Verbinden der zweiten Elektrode mit den elektrischen Verbindungsmitteln (5).

**2.** Verfahren nach Anspruch 1, wobei ein elektrisch leitfähiger Drain (35) in der Isolierschicht (9) vorgesehen ist, um die Aluminiumschicht (11) mit der ersten Elektrode (3) elektrisch zu verbinden.

3. Verfahren nach Anspruch 1 oder 2, wobei mehrere Relativfeuchtigkeitssensoren auf demselben unteren Substrat (1) ausgebildet sind, und wobei die ersten Elektroden (3) so vorgesehen sind, dass sie elektrisch miteinander verbunden sind.

4. Verfahren nach einem der Ansprüche 1 bis 3, wobei die Porosität der anorganischen porösen dielektrischen Schicht (13) in einem Bereich von 5% bis 99% liegt.

5. Verfahren nach einem der vorherigen Ansprüche, wobei die Abscheidung mit streifendem Einfall eine Metalldampfabscheidung mit streifendem Einfall ist.

6. Verfahren nach einem der vorherigen Ansprüche, wobei der Winkel zwischen dem Fluss von verdampftem Material und der Oberfläche der anorganischen porösen dielektrischen Schicht (13) weniger als 45°, insbesondere weniger als 30° beträgt.

7. Verfahren nach einem der vorherigen Ansprüche, wobei das Substrat (1) ein passives Substrat, insbesondere ein Si- oder Saphirsubstrat, oder ein Substrat des ASIC-(Application-Specific Integrated Circuit)-Typs ist.

8. Verfahren nach einem der vorherigen Ansprüche, das ferner einen Schritt des Aufbringens einer leitfähigen Schicht (7) auf die erste Elektrode (3) vor Schritt c) beinhaltet.

9. Verfahren nach einem der vorherigen Ansprüche, wobei die Dicke der anorganischen porösen dielektrischen Schicht (13) in einem Bereich zwischen 1 $\mu$m und 5 $\mu$m liegt und die laterale Ausdehnung in einem Bereich zwischen 10 $\mu$m und 800 $\mu$m zumindest in einer Dimension liegt.

10. Relativfeuchtigkeitssensor, der Folgendes umfasst:

ein Substrat (1),
eine erste Elektrode (3) und ein elektrisches Verbindungsmittel (5) auf oder über dem Substrat (1),
eine Isolierschicht (9), um die erste Elektrode (3) von dem elektrischen Verbindungsmittel (5) elektrisch zu isolieren,
eine elektrolytisch aufgewachsene poröse dielektrische Aluminiumoxidschicht (13) über der Isolierschicht (9) im Bereich der ersten Elektrode (3), und
eine poröse zweite Elektrode (19) mit einer leitfähigen Schicht, die elektrisch mit dem elektrischen Verbindungsmittel (5) verbunden und in oder über der anorganischen porösen dielektrischen Schicht (13) durch Abscheidung mit streifendem Einfall vorgesehen ist.

11. Relativfeuchtigkeitssensor nach Anspruch 10, **dadurch gekennzeichnet, dass** die anorganische poröse Schicht (13) Aluminiumoxid mit einer Porosität von 5% bis 99% und einer Dicke von 1 $\mu$m bis 5 $\mu$m umfasst.

12. Relativfeuchtigkeitssensor nach Anspruch 10 oder Anspruch 11, wobei die zweite Elektrode (19) eine Goldschicht ist.

**Revendications**

1. Procédé de fabrication d'un capteur d'humidité relative comprenant les étapes consistant à :

a) fournir un substrat inférieur (1),
b) fournir une première électrode (3) et des moyens de connexion électrique (5) sur ou par-dessus le substrat (1),
c) fournir une couche isolante (9) afin d'isoler électriquement la première électrode (3) par rapport aux moyens de connexion électrique,
d) fournir une couche diélectrique d'alumine poreuse (13) par-dessus la couche isolante (9) dans la zone de la première électrode (3) grâce au dépôt d'une couche d'aluminium (11) sur la couche isolante (9) et faire croître la couche d'alumine poreuse (13) grâce à la croissance électrolytique, et
e) fournir une deuxième électrode poreuse (19) dans ou par-dessus la couche diélectrique poreuse (13) grâce au dépôt d'une couche conductrice par dépôt à incidence rasante et connectant électriquement la deuxième électrode aux moyens de connexion électrique (5).

2. Procédé selon la revendication 1, où un drain conducteur électrique (35) est fourni dans la couche isolante (9) afin de connecter électriquement la couche d'aluminium (11) avec la première électrode (3).

3. Procédé selon la revendication 1 ou 2, où une pluralité de capteurs d'humidité relative sont formés sur le même substrat inférieur (1) et où les premières électrodes (3) sont fournies de telle sorte qu'elles soient connectées électriquement l'une à l'autre.

4. Procédé selon l'une des revendications 1 à 3, où la porosité de la couche diélectrique poreuse inorganique (13) se trouve dans une gamme de 5 % à 99 %.

5. Procédé selon n'importe laquelle des revendications précédentes, où le dépôt à incidence rasante est un dépôt de vapeur métallique à incidence rasante.

6. Procédé selon n'importe laquelle des revendications précédentes, où l'angle d'écoulement de matériau évaporé et la surface de la couche diélectrique poreuse inorganique (13) est de moins de 45°, en particulier de moins de 30°.

7. Procédé selon n'importe laquelle des revendications précédentes, où le substrat (1) est un substrat passif, en particulier un substrat de Si ou de saphir, ou un substrat de type circuit intégré à application spécifique (ASIC).

8. Procédé selon n'importe laquelle des revendications précédentes, comprenant en outre une étape de fourniture d'une couche conductrice (7) sur la première électrode (3) avant l'étape c).

9. Procédé selon n'importe laquelle des revendications précédentes, où l'épaisseur de la couche diélectrique poreuse inorganique (13) se trouve dans une gamme entre 1 $\mu$m à 5 $\mu$m et l'extension latérale se trouve dans une gamme entre 10 $\mu$m à 800 $\mu$m au moins dans une dimension.

10. Capteur d'humidité relative comprenant :

   un substrat (1),
   une première électrode (3) et un moyen de connexion électrique (5) sur ou par-dessus le substrat (1),
   une couche isolante (9) pour isoler électriquement la première électrode (3) par rapport au moyen de connexion électrique (5),
   une couche diélectrique d'alumine poreuse à croissance électrolytique (13) par-dessus la couche isolante (9) dans la zone de la première électrode (3), et
   une deuxième électrode poreuse (19) comprenant une couche conductrice connectée électriquement au moyen de connexion électrique (5) et fournie dans ou par-dessus la couche diélectrique poreuse inorganique (13) par un dépôt à incidence rasante.

11. Capteur d'humidité relative selon la revendication 10, **caractérisé en ce que** la couche poreuse inorganique (13) comprend de l'alumine avec une porosité de 5 % à 99 % et une épaisseur de 1 $\mu$m à 5 $\mu$m.

12. Capteur d'humidité relative selon la revendication 10 ou la revendication 11, où la deuxième électrode (19) est une couche d'or.

**Fig. 1A**

**Fig. 1B**

**Fig. 1C**

**Fig. 1D**

**Fig. 1E**

**Fig. 1F**

**Fig. 2A**

**Fig. 2B**

**Fig. 3**

**Fig. 4**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 4651121 A
- US 8783101 B2
- US 20110179861 A1
- US 5607564 A